(19) Europäisches Patentamt

European Patent Office

Office européen des brevets

(11) EP 0 856 892 A2

## (12) EUROPEAN PATENT APPLICATION

(43) Date of publication:
05.08.1998 Bulletin 1998/32

(51) Int. Cl.$^6$: **H01L 29/78**, H01L 29/49

(21) Application number: 97309580.5

(22) Date of filing: 27.11.1997

(84) Designated Contracting States:
AT BE CH DE DK ES FI FR GB GR IE IT LI LU MC
NL PT SE
Designated Extension States:
AL LT LV MK RO SI

(30) Priority: 30.01.1997 JP 16919/97

(71) Applicant:
Oki Electric Industry Co., Ltd.
Tokyo (JP)

(72) Inventors:
• Okihara, Masao
7-12, Toranomon 1-chome, Minato-ku Tokyo (JP)
• Uchida, Hidetsugu
7-12, Toranomon 1-chome, Minato-ku Tokyo (JP)

(74) Representative:
Read, Matthew Charles et al
Venner Shipley & Co.
20 Little Britain
London EC1A 7DH (GB)

(54) **MOSFET and manufacturing method thereof**

(57) In a MOSFET, for restraining deterioration of transistor characteristics due to a hot carrier and enhancing a reliability of a device, first and second gate electrodes are formed by linking two materials having different work functions in the vicinity of a drain and in an N-channel region on a p-type silicon substrate, and an inversion threshold voltage in the vicinity of the drain shifts by a difference in the work function in a minus direction than a threshold voltage in a channel region.

## FIG. 1

## Description

BACKGROUND OF THE INVENTION

1. Field of the Invention

The present invention relates generally to a hyperfine MOSFET and, more particularly, to a MOSFET structure and a manufacturing method thereof, which are capable of enhancing a hot carrier deterioration resistance.

2. Description of the Related Background Art

One of the prior arts hitherto given in this field is stated in, for example, pp.63-71 in "Hot Carrier Effects", written by Eiji Takeda, published by Nikkei McGraw-Hill, Inc..

The MOSFET has been used as a central device in a VLSI technology. With a progress of having made the device hyperfiner, however, it is a matter of importance to secure a reliability thereof. In particular, as disclosed in the above document, it is known that a deterioration of transistor characteristics due to an implantation of the hot carrier into a gate oxide film might cause a large decline in terms of a long-term reliability of the device, and it is required that this deterioration be restrained.

A deteriorating phenomenon by the hot carrier will be briefly explained.

A multiplicity of hot carrier implanting mechanisms exist, however, the implanting mechanism that causes the most intensified deterioration in a normal temperature operation region will be discussed.

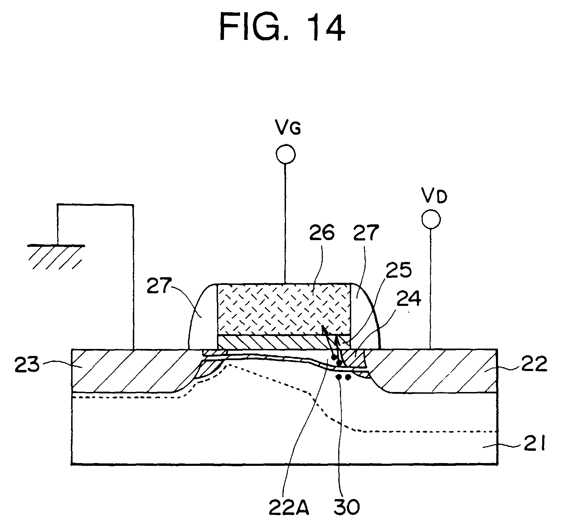

FIG. 14 is a conceptual view showing such a hot carrier deterioration in the prior art MOSFET.

Referring to FIG. 14, there are shown a silicon substrate 21, a high-concentration impurity layer (a drain) 22, a high-concentration impurity layer (a source) 23, a low-concentration impurity layer 24, a gate oxide film 25, a gate electrode 26, and a sidewall 27.

As illustrated in FIG. 14, a high electric field is applied to a drain junction vicinity 22A to make a device hyperfiner. Carriers are accelerated by this electric field, and there is provoked ionisation by a collision with silicon atoms in the vicinity of the drain. Electrons and holes, which are produced at this moment, are implanted into the gate oxide film 25 and function as a trap in the gate oxide film 25, thereby fluctuating transistor characteristics of the MOSFET.

Hot carriers 30 are produced by the high electric field in the drain junction vicinity 22A, and hence, as illustrated in FIG. 14, the electric field can be relaxed enough to restrain an occurrence of the hot carriers 30. Therefore, an LDD-MOSFET structure has widely employed in order to restrain the hot carriers.

Concomitant with the attempt to get the device hyperfiner, however, the high electric field came to be applied in the vicinity of the drain also in the LDD-MOSFET structure, the deterioration of the transistor characteristics due to the hot carriers came into a problem.

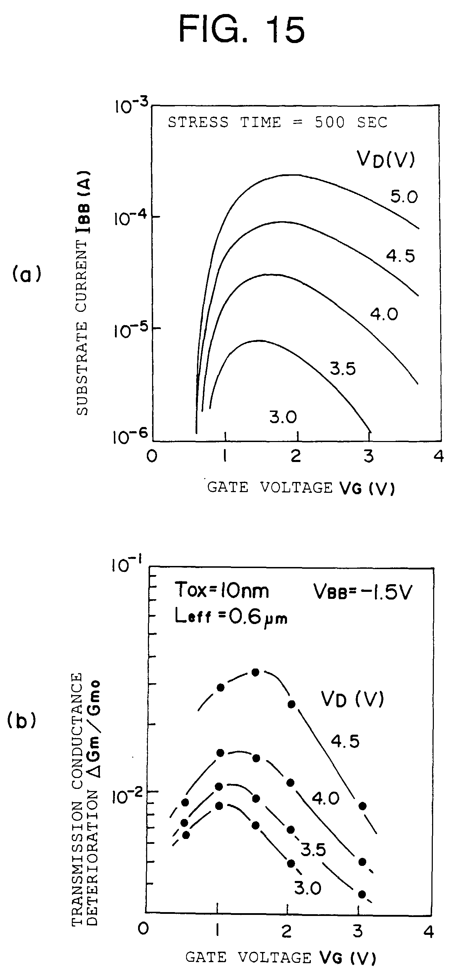

FIG. 15 is a graph showing gate voltage dependencies of a substrate electric current and of a transmission conductance deterioration. FIGS. 15(a) is a graph showing a characteristics between the substrate electric current and the gate voltage. FIG. 15(b) is a graph showing a characteristic between the transmission conductance deterioration and the gate voltage. FIG. 15(b) shows how an n-channel transistor characteristic is deteriorated by the hot carrier as described above.

Referring to FIGS. 15(b), the axis of ordinates indicates a variation quantity ($\Delta Gm/Gmo$) of the transmission conductance deterioration, and the axis of abscissas indicates a gate voltage VG (V).

It can be understood from FIG. 15(b) that the deterioration of the transmission conductance becomes remarkable with an increase in a drain voltage (Vo), and that the maximum deterioration is seen in the vicinity of such a point that the gate voltage VG = 1 / 2Vo. In this case, as shown in FIG. 15(a), the substrate current (188) reaches its maximum, and therefore it can be comprehended that a quantity of occurrence of the hot carrier is maximized under this condition.

Further, when having a larger gate voltage than that, the deterioration of the characteristic turns to decrease, and hence it can be understood that a cause of a decline of reliability of the device may be a deterioration when the gate voltage is as low as VG = 1 / 2V.

It is a primary object of the present invention, which was contrived to obviate the problems given above, to provide a MOSFET and a manufacturing method thereof that are capable of restraining a deterioration of transistor characteristics due to hot carriers, and enhancing a reliability of a device.

SUMMARY OF THE INVENTION

To accomplish the above object, according to a first aspect of the present invention, a MOSFET comprises first and second gate electrodes (6, 7) formed by linking two materials having different work functions in an N-channel region or a P-channel region and in the vicinity of a drain, and a low-concentration diffused drain layer (4) having its front end disposed in a part of the second gate electrode (7). An inversion threshold voltage in the vicinity of the drain shifts farther in a minus direction or in a plus direction by a difference in the work functions than a threshold voltage in the channel region.

According to a second aspect of the present invention, a method of manufacturing a MOSFET comprises a step of forming a gate oxide film (5) on a surface of a silicon substrate (1) and depositing a material of a first gate electrode, a step of executing a patterning process on the first gate electrode (6) without etching the gate oxide film (5) by use of an etching method exhibiting a high selection ratio of the material of the first gate electrode to the gate oxide film (5), a step of depositing a wire material (9), thereafter etching the wire material (9), and forming a second gate electrode (7) having a different work function at least on the drain side of the first gate electrode (6), and a step of forming a low-concentration impurity layer (4), a sidewall (8) and a source/drain (3, 2) composed of a high-concentration impurity layer by use of said first gate electrode and said second gate electrode.

According to a third aspect of the present invention, a method of manufacturing a MOSFET comprises a step of forming a gate oxide film (5) on a surface of a silicon substrate (1), depositing a sacrifice film (10) by a material exhibiting a high selection ratio to the gate oxide film (5), thereafter forming a groove in the sacrifice film (10), and depositing a wire material (9) on the entire surface by a CVD technique, a step of making the wire material (9) remain inwardly of the groove, thereafter completely removing the sacrifice film (10) by etching, and thus forming a first gate electrode (6), a step of depositing a different wire material (11) on the entire surface, thereafter etching this wire material (11), and thus forming a second gate electrode (7) having a different work function at least on a drain side of the first gate electrode (6), and a step of forming a low-concentration impurity layer (4), a sidewall (8) and a source/drain (3, 2) composed of a high-concentration impurity layer by use of the first gate electrode (6) and the second gate electrode (7).

According to a fourth aspect of the present invention, a method of manufacturing a MOSFET comprises a step of forming a gate oxide film (5) on a surface of a silicon substrate (1), thereafter depositing a material of a first gate electrode, and executing a patterning process on the first gate electrode (6) without etching the gate oxide film (5) by use of an etching method exhibiting a high selection ratio of the material of the first gate electrode to the gate oxide film (5), a step of depositing a material of the second gate electrode on an outer periphery of the first gate electrode (6) by selective CVD, and thus forming a second gate electrode (7) having a different work function on the outer periphery of the first gate electrode (6), and a step of forming a low-concentration impurity layer (4), a sidewall (8) and a source/drain (3, 2) composed of a high-concentration impurity layer by use of the first gate electrode (6) and the second gate electrode (7).

According to a fifth aspect of the present invention, a method of manufacturing a MOSFET comprises a step of forming a gate oxide film (5) on a surface of a silicon substrate (1), thereafter depositing a material of a first gate electrode and executing a patterning process on the first gate electrode (6) without etching the gate oxide film (5) by use of an etching method exhibiting a high selection ratio of the material of the gate electrode to the gate oxide film (5), a step of depositing such a wire material (12) as forming silicide that reacts to silicon and is stable at a high temperature, thereafter forming a silicide layer on an outer periphery of the first gate electrode (6) by effecting a high-temperature thermal treatment, and forming a second gate electrode (7) having a different work function on the outer periphery of the first gate electrode (6) by selectively removing the non-reacted wire material (12), and a step of forming a low-concentration impurity layer (4), a sidewall (8) and a source/drain (3, 2) composed of a high-concentration impurity layer by use of the first gate electrode and the second gate electrode.

According to a sixth aspect of the present invention, a MOSFET comprises a channel region and a drain, wherein a substrate concentration $N_{ch}$ of the channel region is different from a substrate concentration $N_D$ in the vicinity of the drain, and an inversion threshold voltage in the vicinity of the drain shifts farther corresponding to a difference between the substrate concentrations in a minus direction than a threshold voltage in the channel region.

According to a seventh aspect of the present invention, a method of manufacturing a MOSFET comprises a step of forming a gate oxide film (5) on a surface of a p-type silicon substrate (1), thereafter depositing a material of a first gate electrode (13), and executing a patterning process on the first gate electrode (13) without etching the gate oxide film (5) by use of an etching method exhibiting a high selection ratio of the material of the gate electrode to the gate oxide film (5), a step of implanting ions at an acceleration voltage to such a degree that a impurity (14) is implanted through the first gate electrode (13) into a substrate surface, a step of depositing a material on an entire surface, etching this material, and forming a second gate electrode (16) composed of the same material in a sidewall-like shape on both sides of the first gate electrode (13), and a step of forming a low-concentration impurity layer (4), a sidewall (8) and a source/drain (3, 2) composed of a high-concentration impurity layer by use of the first gate electrode (13) and the second gate electrode (16).

According to an eighth aspect of the present invention, a method of manufacturing a MOSFET comprises a step of forming a gate oxide film (5) on a surface of a p-type silicon substrate (1), thereafter depositing a material of a first gate electrode, and executing a patterning process on the first gate electrode (13) without etching the gate oxide film (5) by use of an etching method exhibiting a high selection ratio of the material of the gate electrode to the gate oxide film (5), a step of implanting ions at an acceleration voltage to such a degree that am n-type impurity (15) is implanted into a substrate surface, a step of depositing the same material as that of the first gate electrode (13) on an entire surface, etching this material, and forming a second gate electrode (16) in a sidewall-like shape on both sides of the first gate electrode (13), and a step of forming a low-concentration impurity layer (4), a sidewall (8) and a source/drain (3, 2) composed of an n-type high-concentration impurity layer by use of the first gate electrode (13) and the second gate electrode (16).

According to a ninth aspect of the present invention, a MOSFET is constructed such that a gate oxide film (5) is so formed as to be small in thickness in the vicinity of a drain, a capacity of the gate oxide film (5) consequently becomes larger than that in a channel region, and an inversion threshold voltage in the vicinity of the drain thereby shifts in a minus direction.

According to a tenth aspect of the present invention, a method of manufacturing a MOSFET comprises a step of forming a gate oxide film (5) on a surface of a silicon substrate (1), thereafter depositing a material of a first gate electrode, and executing a patterning process on the first gate electrode (13) without etching the gate oxide film (5) by use of an etching method exhibiting a high selection ratio of the material of the gate electrode to the gate oxide film (5), a step of decreasing a thickness of the gate oxide film (5) in a region that is not covered with the first gate electrode (13) by using an etchant with respect to a silicon oxide film, a step of depositing a material on an entire surface, etching this material, and forming a second gate electrode (16) in a sidewall-shape on both sides of the first gate electrode (13), and a step of forming a low-concentration impurity layer (4), a sidewall (8) and a source/drain (3, 2) composed of a high-concentration impurity layer by use of the first gate electrode and the second gate electrode.

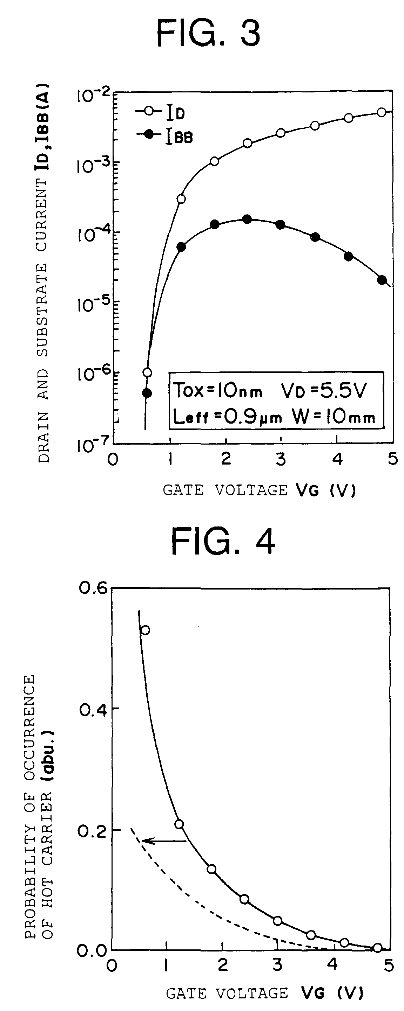

Hot carrier deterioration becomes the maximum at a point that the gate voltage $V_G = 1/2\ V_D$ ($V_D$: drain voltage) is satisfied (see FIG. 15(b)), because the possibility of occurrence of hot carrier is large at that time (see FIG. 4) and because hot carrier, which occurs since vertical electric field generating at the overlap region between the gate electrode and the drain junction is large, is easily injected into the gate oxide film by this electric field. In other words, the hot carrier inject efficiency becomes large by the vertical electric field generating at the overlap region between the gate electrode and the drain junction. This vertical electric field can be weaken by increasing the gate voltage ($V_G$).

In the present invention, a main gate electrode and a gate electrode having different work functions are arranged in the overlap region between the gate electrode and the drain junction, whereby the gate voltage in this region increases in accordance with the difference between the work functions. With this arrangement, the vertical electric field generating at the overlap region between the gate electrode and the drain junction is weaken, therefore, it becomes possible to lower the hot carrier inject efficiency into the gate oxide film. To achieve this effect, it is necessary that the gate electrode having a work function different from the main gate electrode is larger than the overlap region between the gate electrode and the drain junction, at which vertical electric field generates.

## BRIEF DESCRIPTION OF THE DRAWINGS

Other objects and advantages of the present invention will become apparent during the following discussion in conjunction with the accompanying drawings, in which:

FIG. 1 is a view of a construction of a MOSFET, showing a first embodiment of the present invention;

FIG. 2 is a view of a band of a MOS structure in a channel region of a gate electrode and in the vicinity of a drain in the first embodiment of the present invention;

FIG. 3 is a graph showing a gate voltage dependency of a drain current and a substrate electric current;

FIG. 4 is a graph showing a gate voltage dependency of a probability of occurrence of a hot carrier;

FIG. 5 is a sectional of processes of manufacturing the MOSFET, showing a second embodiment of the present invention;

FIG. 6 is a sectional view of processes of manufacturing the MOSFET, showing a third embodiment;

FIG. 7 is a sectional view of processes of manufacturing the MOSFET, showing a fourth embodiment of the present invention;

FIG. 8 is a sectional view of processes of manufacturing the MOSFET, showing a fifth embodiment of the present invention;

FIG. 9 is a view of a construction of the MOSFET, showing a sixth embodiment of the present invention;

FIG. 10 is a sectional view of processes of manufacturing the MOSFET, showing a seventh embodiment of the present invention;

FIG. 11 is a sectional view of processes of manufacturing the MOSFET, showing an eighth embodiment of the present invention;

FIG. 12 is a view of a construction of the MOSFET, showing a ninth embodiment of the present invention;

FIG. 13 is a sectional view of processes of manufacturing the MOSFET, showing a tenth embodiment of the present invention;

FIG. 14 is a conceptual view showing a deterioration by the hot carriers in a prior art MOSFET; and

FIG. 15 is a graph showing gate voltage dependencies of a substrate electric current and of a transmission conductance deterioration.

## DETAILED DESCRIPTION OF THE PREFERRED EMBODIMENTS

Preferred embodiments of the present invention will hereinafter be described with reference to the accompanying drawings. The explanations are herein centered on an NMOS.

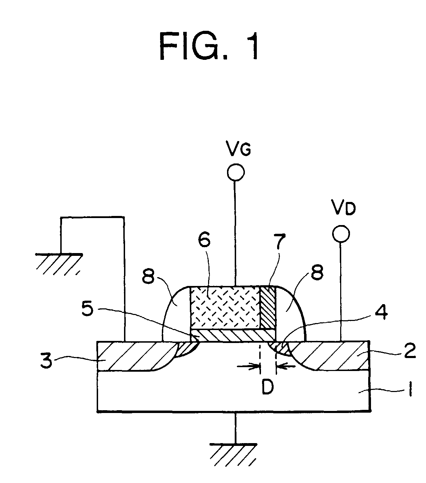

FIG. 1 is a view of a structure of a MOSFET, showing a first embodiment of the present invention.

Referring to FIG. 1, there are shown a p-type silicon substrate 1, an n-type high-concentration impurity layer (a drain) 2, an n-type high-concentration impurity layer (a source) 3, an n-type low-concentration impurity layer 4, a gate oxide film 5, a first gate electrode 6, a second gate electrode 7, and a sidewall 8.

In accordance with the first embodiment, as explained above, the first gate electrode 6 and the second gate electrode 7 are formed by linking two materials each having a different work function.

At this time, a region D of the second gate electrode 7 on the drain side may be formed wider than a region in which a drain junction is overlapped with the gate electrode. It is desirable that a difference in the work function between the materials of the gate electrodes 6, 7 be 1V or larger.

The MOSFET is thereby structured so that an inversion threshold voltage in the vicinity of the drain shifts farther in a minus direction by the work function difference than in an N-channel region.

Next, an operation of the n-channel MOSFET will be discussed.

In an ideal MOS structure, an inversion threshold voltage ($V_{th}$) can be expressed by the following formula using a Fermi potential ($\phi_f$) of a p-type semiconductor.

$$V_{th} = 2\phi_f + [\sqrt{2K_{\varepsilon o}} qN_A (2\phi_f) / C_o \qquad (1)$$

where K is the relative dielectric constant, $N_A$ is the impurity concentration of the p-type semiconductor, and $C_o$ is the capacity per unit area of the gate oxide film 5. Further, if an electric charge exists in the gate oxide film 5, or if there is a difference in the work function between the first gate electrode 6, the second gate electrode 7 and the silicon substrate 1, it follows that a surface potential deviates corresponding thereto. This deviation is termed a flat band voltage ($V_{FB}$), and the above formula (1) is rewritten such as:

$$V_{th} = 2\phi_f + V_{FB} + [\sqrt{2K_{\varepsilon o}} qN_A (2\phi_f) / C_o \qquad (2)$$

In accordance with the first embodiment, the inversion threshold voltage in the vicinity of the drain shift farther in the minus direction than in the channel region, and hence it can be known from the formula (2) that the flat band voltage in the vicinity of the drain is a value smaller by the difference in the work function.

Herein, supposing that the difference in the work function therebetween be 1V, it follows that the flat band voltage in the vicinity of the drain may be obtained by subtracting 1V from that in the channel region.

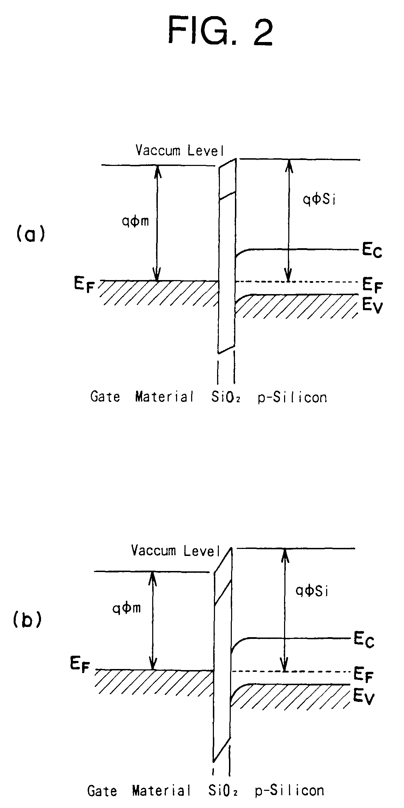

FIG. 2 is a view showing bands of MOS structures in the channel region of the gate electrode as well as in the vicinity of the drain in the first embodiment of the present invention. Shown herein is a case of a gate voltage $V_G = 0V$.

The work function of the material of the first electrode 6 in the channel region is smaller than that of the silicon substrate 1, in which case the surface of the silicon substrate 1 becomes void as illustrated in FIG. 2(a). In contrast with this, the work function of the material of the second gate electrode 7 is much smaller by 1V in the vicinity of the drain, and hence, as shown in FIG. 2(b), it follows that the surface of the silicon substrate 1 becomes void more intensively. This, in other words, implies a condition equivalent to a state where a gate voltage higher by 1V from the beginning than in the channel region is applied in the vicinity of the drain.

FIG. 3 shows a gate voltage ($V_G$) dependency of a drain current ($I_D$) (marked with O) and a substrate current ($I_{BB}$) (marked with ●), wherein a drain voltage ($V_D$) of an n-channel MOSFET is 5.5V, the MOSFET having a gate oxide film thickness ($T_{OX}$) of 10 nm, a transistor effective length ($L_{eff}$) of 0.9 μm and a width (W) of 10 mm.

As obvious from FIG. 3, it can be understood that the drain current ($I_D$) increases with a rise in the gate voltage, whereas the substrate current ($I_{BB}$) reaches a peak in the vicinity of $V_G = 1/2\ V_D$, and thereafter goes on decreasing. An occurrence of a hot carrier depends on the drain current ($I_D$), while the substrate current ($I_{BB}$) is proportional to a quantity of occurrence of the hot carrier. Hence, a probability of occurrence of the hot carrier can be obtained by dividing the substrate current ($I_{BB}$) by the drain current ($I_D$).

FIG. 4 shows a probability of occurrence of the hot carrier and also a gate voltage dependency.

As apparent from FIG. 4, it can be comprehended that probability of occurrence of the hot carrier becomes higher with the smaller gate voltage, and decreases exponentially with the rise in the gate voltage.

Thus, according to the structure of the MOSFET in the first embodiment, in the vicinity of the drain, there must be a condition equivalent to a state where a gate voltage higher by the difference in the work function than in the channel region, is applied. Therefore, the probability of occurrence of the hot carrier shifts leftward as indicated by a dotted line in FIG. 4. The quantity of occurrence of the hot carrier may be obtained by multiplying this by the drain current. For this reason, supposing that the difference in the work function is approximately 1V, the quantity of occurrence of the hot carrier can be reduced down to approximately 1/2.

Simultaneously, the deterioration by the hot carrier can be also reduced down to approximately 1/2.

Given next is an explanation of a method of manufacturing the MOSFET in a second embodiment of the present invention.

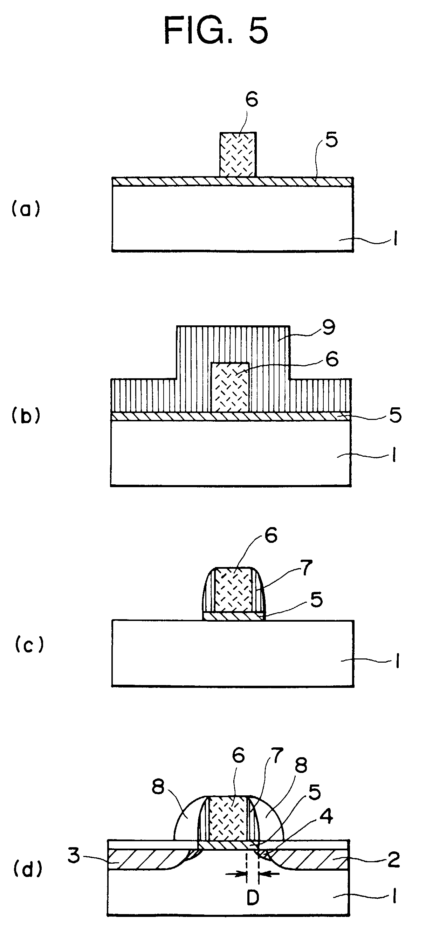

FIG. 5 is a sectional view showing processes of manufacturing the MOSFET in the second embodiment of the present invention.

(1) To begin with, as shown in FIG. 5(a), a gate oxide film 5 is formed on the surface of the p-type silicon substrate 1 by a process such as thermal oxidation, etc., and thereafter the first gate electrode 6 is deposited by a technique such as sputtering. Then, the patterning process is executed by use of the known photolithography etching technique. At this time, the gate oxide film 5 is not etched by use of an etching method exhibiting a high selection ratio of the material of the first gate electrode 6 to the gate oxide film 5.

(2) Thereafter, as shown in FIG. 5(b), a wire material 9 is deposited over the entire surface.

(3) Subsequently, this wire material 9 is etched, thereby forming, as illustrated in FIG. 5(c), the second gate electrodes 7 each having a work function in a sidewall-like shape on both sides of the material of the first gate electrode 6.

For example, polycrystal silicon into which a p-type impurity is doped with a high concentration is used as a material of the first gate electrode 6 of the n-channel MOSFET, and a material such as Al or Ti is used for the gate electrode 7 thereof, whereby a difference in the work function therebetween can be set to approximately 1V.

(4) In the same way as an ordinary MOSFET manufacturing method, the low-concentration impurity layer 4, the sidewall 8 and the high-concentration impurity layers 2, 3 are formed by use of the first gate electrode 6 and the second gate electrode 7, thereby making it feasible to construct the MOSFET having the structure in the second embodiment as shown in FIG. 5(d).

Thus, in accordance with the second embodiment, the MOSFET can be constructed with no increased number of masks as compared with the prior art MOSFET manufacturing method.

According to the structure of the thus constructed MOSFET, in the vicinity of the drain, there must be the condition equivalent to the state where the gate voltage higher by the difference in the work function than in the channel region is applied, and hence the probability of occurrence of the hot carrier shifts leftward as indicated by the dotted line in FIG. 4. The quantity of occurrence of the hot carrier may be obtained by multiplying this by the drain current. For this reason, supposing that the difference in the work function is approximately 1V, the quantity of occurrence of the hot carrier can be reduced down to approximately 1/2. At the same time, the deterioration by the hot carrier can be also reduced down to approximately 1/2.

Next, a third embodiment of the present invention will be explained.

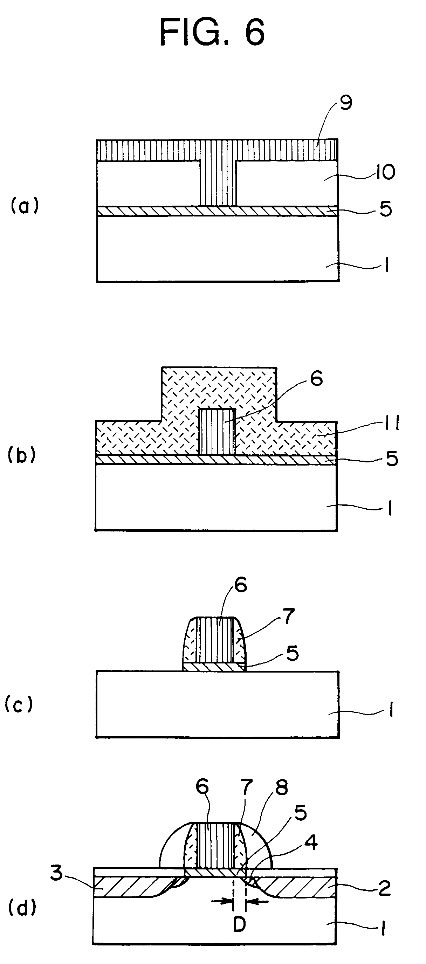

FIG. 6 is a sectional view of processes of manufacturing the MOSFET, showing the third embodiment of the present invention.

(1) First of all, as illustrated in FIG. 6(a), after the gate oxide film 5 has been formed on the surface of the p-type silicon substrate 1 by a process such as thermal oxidation, etc., a sacrifice film 10 is deposited. At this time, the sacrifice film 10 involves the use of a material having a sufficiently high selection ratio to the gate oxide film 5 on the occasion of the etching process later on. A groove is formed in this sacrifice film 10 by the known photolithography etching technique, and thereafter a wire material 9 is deposited over the entire surface by a CVD (Chemical Vapor Deposition) technique.

(2) Subsequently, this wire material 9 is left inwardly of the groove by a CMP (Chemical mechanical Polishing) technique, and thereafter, the sacrifice film 10 is completely removed by etching. The first gate electrode 6 is thereby formed as illustrated in FIG. 6(b). Thereafter, a different material 11 is further deposited over the entire surface.

(3) Next, as shown in FIG. 6(c), this wire material 11 is etched, whereby the second gate electrodes 7 each having a different work function are formed in the sidewall-like shape on the both sides of the first gate electrode 6. For instance, the polycrystal silicon into which the p-type impurity is doped with a high concentration is used as a material of the first gate electrode 6 of the n-channel MOSFET, and the material such as Al or Ti is used for the second gate electrode 7 thereof, whereby a difference in the work function therebetween can be set to approximately 1V.

In the same way as the ordinary MOSFET manufacturing method, the n-type low-concentration impurity layer 4, the sidewall 8 and the n-type high-concentration impurity layers 2, 3 are formed by use of those gate electrodes 6, 7, thereby making it feasible to obtain the MOSFET having the structure in the third embodiment as shown in FIG. 6(d).

Thus, in accordance with the third embodiment, the MOSFET having the structure in the first embodiment can be constructed with no increased number of masks as compared with the prior art MOSFET manufacturing method.

According to the structure of the thus constructed MOSFET, in the vicinity of the drain, there must be the condition equivalent to the state where the gate voltage higher by the difference in the work function than in the channel region is applied, and hence the probability of occurrence of the hot carrier shifts leftward as indicated by the dotted line in FIG. 4. The quantity of occurrence of the hot carrier may be obtained by multiplying this by the drain current. For this reason, supposing that the difference in the work function is approximately 1V, the quantity of occurrence of the hot carrier can be reduced down to approximately 1/2. At the same time, the deterioration by the hot carrier can be also reduced down to approximately 1/2.

Next, a fourth embodiment of the present invention will be described.

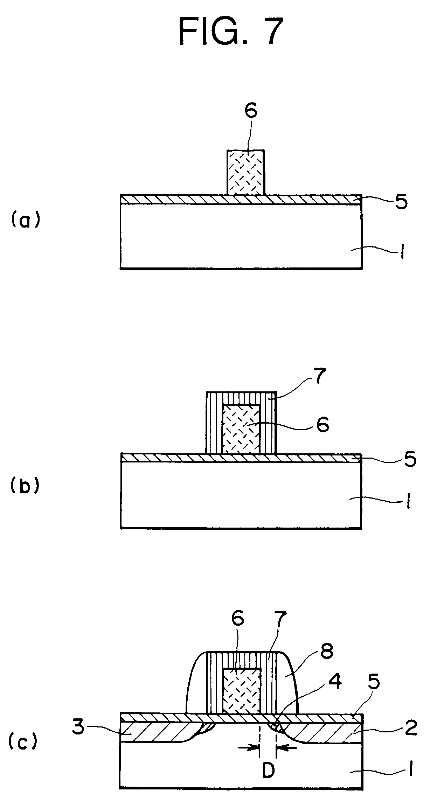

FIG. 7 is a sectional view of processes of manufacturing the MOSFET, showing the fourth embodiment of the present invention.

(1) To start with, as illustrated in FIG. 7(a), after the gate oxide film 5 has been formed on the surface of the p-type silicon substrate 1 by a process such as the thermal oxidation, etc., the gate electrode 6 is deposited by a technique such as sputtering, and a patterning process is implemented by the known photolithography etching technique. At this time, the gate oxide film 5 is not etched by employing the etching method exhibiting the high selection ratio of the first gate electrode to the gate oxide film 5.

(2) Thereafter, as shown in FIG. 7(b), the second gate electrode 7 is deposited on only an outer periphery of the first gate electrode 6 by the selective CVD, thereby forming the second gate electrode 7 having a different work function on the outer periphery of the material of the first gate electrode 6.

For example, the polycrystal silicon into which the p-type impurity is doped with a high concentration is used as a material of the first gate electrode 6 of the n-channel MOSFET, and a material such as Al known as being possible of the selective CVD is used for the gate electrode 7 thereof, whereby a difference in the work function therebetween can be set to approximately 1V.

(3) In the same way as the ordinary MOSFET manufacturing method, the n-type low-concentration impurity layer 4, the sidewall 8 and the n-type high-concentration impurity layers 2, 3 are formed by use of those gate electrodes 6, 7, thereby making it possible to construct the MOSFET having the structure in the fourth embodiment as shown in FIG. 7(c).

Thus, in accordance with the fourth embodiment, the MOSFET can be constructed with no increased number of masks as compared with the prior art MOSFET manufacturing method.

According to the structure of the thus constructed MOSFET, in the vicinity of the drain, there must be the condition equivalent to the state where the gate voltage higher by the difference in the work function than in the channel region is applied, and hence the probability of occurrence of the hot carrier shifts leftward as indicated by the dotted line in FIG. 4. The quantity of occurrence of the hot carrier may be obtained by multiplying this by the drain current. For this reason, supposing that the difference in the work function is approximately 1V, the quantity of occurrence of the hot carrier can be reduced down to approximately 1/2. At the same time, the deterioration by the hot carrier can be also reduced down to approximately 1/2.

Next, a fifth embodiment of the present invention will be explained.

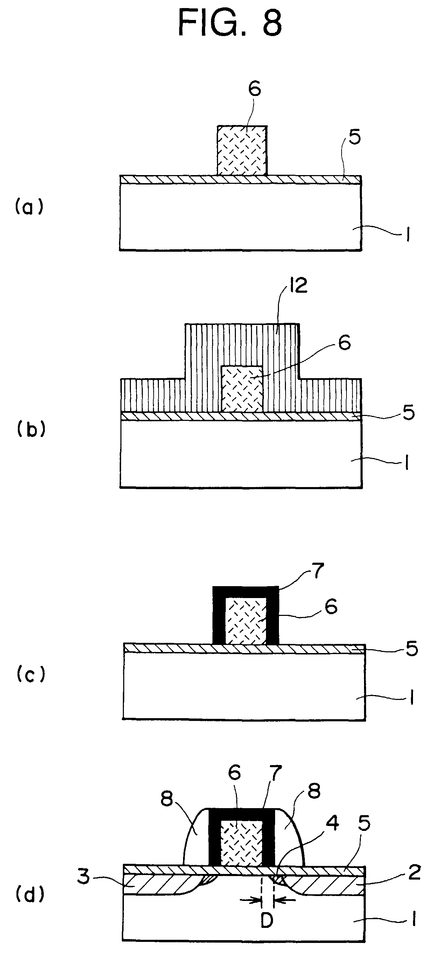

FIG. 8 is a sectional view of processes of manufacturing the MOSFET, showing the fifth embodiment of the present invention.

(1) To begin with, as illustrated in FIG. 8(a), after the gate oxide film 5 has been formed on the surface of the p-type silicon substrate 1 by a process such as thermal oxidation, etc., the first gate electrode 6 is deposited by a technique such as sputtering, etc., and the patterning process is implemented by employing the known photolithography etching technique. At this time, the gate oxide film 5 is not etched by use of the etching method exhibiting a high selection ratio of the first gate electrode 6 to the gate oxide film 5.

(2) Thereafter, as shown in FIG. 8(b), such a wire material 12 as forming silicide that reacts to silicon and is stable at a high temperature, is deposited over the entire surface.

(3) Thereafter, as illustrated in FIG. 8(c), a silicide layer is formed on the outer periphery of the first gate electrode 6 by executing a thermal treatment at the high temperature, and an non-reacted part of wire material 12 is selectively removed, thereby forming the second gate electrode 7 having a different work function on the outer periphery of the first gate electrode 6.

For instance, the polycrystal silicon into which the p-type impurity is doped with a high concentration is used as a material of the first gate electrode 6 of the n-channel MOSFET, and a material such as Ti silicide, etc. is used for the gate electrode 7 thereof, whereby a difference in the work function therebetween can be set to approximately 1V.

In the same way as the ordinary MOSFET manufacturing method, the n-type low-concentration impurity layer 4, the sidewall 8 and the n-type high-concentration impurity layers 2, 3 are formed by use of those gate electrodes 6, 7, thereby making it feasible to construct the MOSFET having the structure in the fifth embodiment as shown in FIG. 8(d).

Thus, in accordance with the fifth embodiment, the MOSFET can be constructed with no increased number of masks as compared with the prior art MOSFET manufacturing method.

According to the structure of the thus constructed MOSFET, in the vicinity of the drain, there must be the condition equivalent to the state where the gate voltage higher by the difference in the work function than in the channel region is applied, and hence the probability of occurrence of the hot carrier shifts leftward as indicated by the dotted line in FIG. 4. The quantity of occurrence of the hot carrier may be obtained by multiplying this by the drain current. Therefore, assuming that the difference in the work function is approximately 1V, the quantity of occurrence of the hot carrier can be reduced down to approximately 1/2. Simultaneously, the deterioration by the hot carrier can be also reduced down to approximately 1/2.

Next, a sixth embodiment of the present invention will be explained.

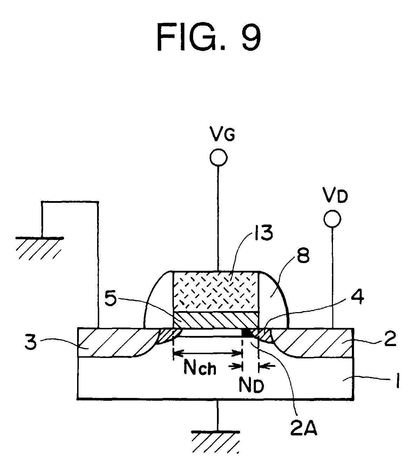

FIG. 9 is a view of a construction of the MOSFET, showing the sixth embodiment of the present invention. Note that the same components as those in the first embodiment are marked with the like numerals, and the explanations thereof are omitted.

As illustrated in FIG. 9, the sixth embodiment is such that a substrate concentration $N_{ch}$ in the channel region is different from a substrate concentration $N_D$ in the vicinity of the drain. Note that the numeral 13 designates a first electrode.

In such a case, a region of the substrate concentration $N_D$ on the drain side may be formed to such an extent as to spread more inwardly of the channel than a drain junction 2A. These two substrate concentrations are not necessarily limited, however, the MOSFET is hereby structured such that an inversion threshold voltage in the vicinity of the drain shafts farther in the minus direction than in the channel region.

Next, an operation of the n-channel MOSFET in the sixth embodiment will be discussed.

As obvious from the formula (2) given above, a substrate concentration $N_A$ of the semiconductor is one of the inversion threshold voltages and is therefore varied, thereby enabling the inversion threshold voltage to shift.

If the substrate concentration $N_A$ is on the order of $1 \times 10^{16} cm^{-3}$, the third item of the formula (2) becomes approximately 1V. Therefore, the concentration of the Nch region in FIG. 9 is set quadruple as large as the substrate concentration, with the result that the third item becomes 2V , and that the inversion threshold voltage shafts by 1V on a plus side. Namely, in other words, in the proximity to the drain, there must be a condition equivalent to a state where a gate voltage higher by 1V than in the channel region is applied from the beginning.

As described above, according to the structure of the MOSFET in the sixth embodiment, in the vicinity of the drain, there must be the condition equivalent to the state in which there is applied the gate voltage higher than in the channel region due to a difference between the substrate concentrations, and hence the probability of occurrence of the hot carrier shifts leftward as indicated by the dotted line in FIG. 4. The quantity of occurrence of the hot carrier may be obtained by multiplying this by the drain current.

For this reason, assuming that there must be a condition where the gate voltage becomes higher by 1V due to the difference between the substrate concentrations, the quantity of occurrence of the hot carrier can be reduced down to approximately 1/2, and simultaneously the deterioration by the hot carrier can be also reduced down to approximately 1/2.

Next, a seventh embodiment of the present invention will be explained.

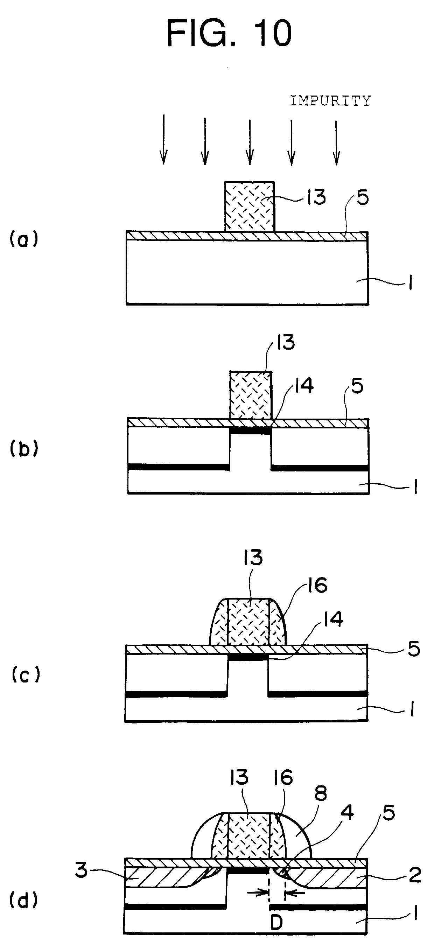

FIG. 10 is a sectional view of processes of manufacturing the MOSFET, showing the seventh embodiment of the present invention.

(1) First of all, as illustrated in FIG. 10(a), after the gate oxide film 5 has been formed on the surface of the p-type silicon substrate 1 by a process such as the thermal oxidation, etc., a first gate electrode 13 is deposited by a technique such as sputtering, and a patterning process is implemented by the known photolithography etching technique. At this time, the oxide film 5 is not etched by employing the etching method exhibiting the high selection ratio of a material of the first gate electrode 13 to the gate oxide film 5. Thereafter, the p-type impurity is ion-implanted into the whole surface.

(2) At this moment, as shown in FIG. 10(b), the p-type impurity passes through the first gate electrode 13 and is ion-implanted at an acceleration voltage to such a degree as to be implanted into the substrate surface. In this case, a p-type impurity layer 14 is formed on only the substrate surface of the first gate electrode 13, and the p-type impurity is implanted inside the substrate in an area where no first gate electrode exists, which therefore makes almost no contribution to the operation of the MOSFET.

(3) Thereafter, the same material as that of the first gate electrode 13 is deposited over the whole surface, and this material is etched, whereby a second gate electrode 16 composed of the same material is, as illustrated in FIG. 10(c), in a sidewall-like shape on both sides of the first gate electrode 13. At this time, in the same way as the ordinary MOSFET manufacturing method, the n-type low-concentration impurity layer 4, the sidewall 8 and the n-type high-concentration impurity layers 2, 3 are formed by use of those gate electrodes 13, 16, thereby making it possible to construct the MOSFET having the structure in the seventh embodiment as shown in FIG. 10(d).

Thus, in accordance with the seventh embodiment, the MOSFET can be constructed with no increased number of masks as compared with the prior art MOSFET manufacturing method.

According to the structure of the thus constructed MOSFET, in the vicinity of the drain, there must be the condition equivalent to the state where there is applied the gate voltage higher than in the channel region due to the difference between the substrate concentrations, and hence the probability of occurrence of the hot carrier shifts leftward as indicated by the dotted line in FIG. 4. The quantity of occurrence of the hot carrier may be obtained by multiplying this by the drain current. For this reason, supposing that the gate voltage is higher by approximately 1V due to the difference between the substrate concentrations, the quantity of occurrence of the hot carrier can be reduced down to approximately 1/2. At the same time, the deterioration by the hot carrier can be also reduced down to approximately 1/2.

Next, an eighth embodiment of the present invention will be explained.

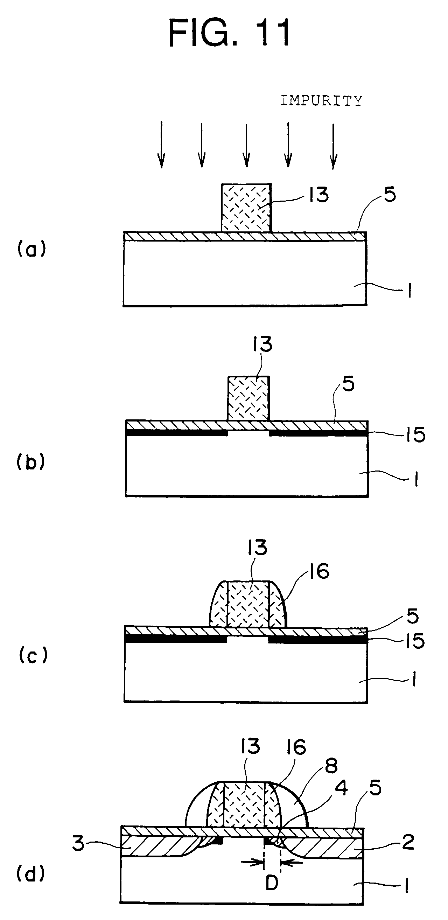

FIG. 11 is a sectional view of processes of manufacturing the MOSFET, showing the eighth embodiment of the present invention.

(1) First of all, as illustrated in FIG. 11(a), after the gate oxide film 5 has been formed on the surface of the p-type silicon substrate 1 by a process such as the thermal oxidation, etc., the first gate electrode 13 is deposited by sputtering, and the patterning process is executed by using the known photolithography etching technique. At this time, the gate oxide film 5 is not etched by use of the etching exhibiting a high selection ratio of the material of the first gate electrode 13 to the gate oxide film 5. Thereafter, an n-type impurity is ion-implanted into the entire surface.

(2) A this time, as shown in FIG. 11(b), the n-type impurity is ion-implanted at an acceleration voltage to such a degree as to be implanted into the substrate surface. In this case, in an area where no first gate electrode 13 exists, the n-type impurity is intercepted by the first gate electrode 13 and therefore not implanted into the substrate, and an n-type impurity layer 15 is formed on only a region excluding the first gate electrode 13.

(3) Thereafter, the same material as that of the first gate electrode 13 is deposited over the whole surface, and this material is etched, whereby the second gate electrode 16 composed of the same material is, as illustrated in FIG. 11(c), in a sidewall-like shape on both sides of the first gate electrode 13.

(4) At this time, in the same way as the ordinary MOSFET manufacturing method, the n-type low-concentration impurity layer 4, the sidewall 8 and the n-type high-concentration impurity layers 2, 3 are formed by use of those gate electrodes 13, 16, and an embedded-channel MOSFET is thereby constructed in the vicinity of the drain region, resulting in such a state that a threshold voltage becomes lower than in the channel region. This makes it feasible to construct the MOSFET having the structure in the eighth embodiment as illustrated in FIG. 11(d).

Thus, in accordance with the eighth embodiment, the MOSFET can be constructed with no increased number of masks as compared with the prior art MOSFET manufacturing method.

According to the structure of the thus constructed MOSFET, in the vicinity of the drain, there must be the condition equivalent to the state where there is applied the gate voltage higher than in the channel region due to the difference between the substrate concentrations, and hence the probability of occurrence of the hot carrier shifts leftward as indicated by the dotted line in FIG. 4. The quantity of occurrence of the hot carrier may be obtained by multiplying this by the drain current. For this reason, supposing that the gate voltage is higher by approximately 1V due to the difference between the substrate concentrations, the quantity of occurrence of the hot carrier can be reduced down to approximately 1/2, and the deterioration by the hot carrier can be also reduced down to approximately 1/2.

Next, a ninth embodiment of the present invention will be explained.

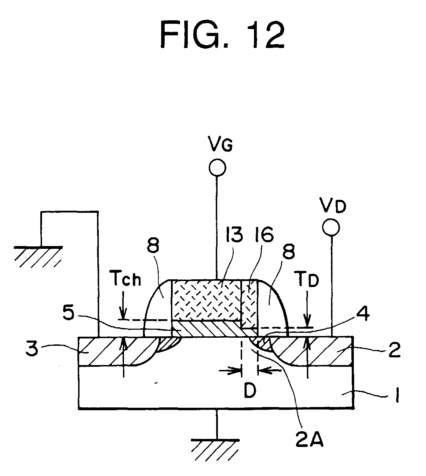

FIG. 12 is a view of a construction of the MOSFET, showing the ninth embodiment of the present invention. Note that the same components as those in the first and sixth embodiments are marked with the like numerals, and the explanations thereof are omitted.

In the ninth embodiment, as illustrated in FIG. 12, a film thickness $T_D$ of the gate oxide film 5 in the vicinity of the drain is thinner than a film thickness Tch of the channel region.

At this time, a region in which the gate oxide film 5 is thinned may be formed wider than a region where a drain junction 2A is overlapped with the first gate electrode 13. It is desirable that the film thickness of the gate oxide film 5 in the vicinity of the drain, although not particularly confined on condition that it is thinner than the channel region, be set to approximately 1/2 in terms of a magnitude of the effect.

The MOSFET is structured so that the inversion threshold voltage in the vicinity of the drain shifts in farther in the minus direction than in the channel region because of an increased capacity of the gate oxide film 5 due to the above arrangement.

Next, an operation of the n-channel MOSFET in the ninth embodiment will be described.

As the thickness of the gate oxide film 5 is small in the vicinity of the drain, the capacity of the gate oxide film 5 increases in inverse proportion thereto. A capacity $C_0$ of the gate oxide film 5 is, as obvious from the formula (2) given above, one of the inversion threshold voltages, and hence the threshold voltage can be shifted by changing this capacity $C_0$. Herein, assuming that the thickness of the gate oxide film 5 in the vicinity of the drain is 1/2 as small as that of the channel region, the capacity of the oxide film 5 in the vicinity of the drain becomes twice that of the channel region.

In the normal MOSFET, the third term in the formula (2) is on the order of 1V and therefore becomes 0.5V in the vicinity of the drain, and it follows that the inversion threshold value shifts in the minus direction corresponding thereto. Namely, in other words, the thickness of the gate oxide film 5 is larger than the channel region in the vicinity of the drain, and there must be the condition equivalent to the state where the high gate voltage is applied.

Thus, according to the structure of the MOSFET in the vicinity of the drain, since the thickness of the gate oxide film 5 is smaller than the channel region, there must be the condition equivalent to the state in which the high gate voltage is applied. Therefore, the probability of occurrence of the hot carrier shifts leftward as indicated by the dotted line in FIG. 4. The quantity of occurrence of the hot carrier may be obtained by multiplying this by the drain current.

For this reason, there is a condition in which the gate voltage is higher by approximately 0.5V because of the smaller thickness of the gate oxide film 5, in which case the quantity of occurrence of the hot carrier can be reduced down to approximately 2/3. Simultaneously, the capacity of the gate oxide film 5 increases in the inverse proportion to the film thickness in the vicinity of the drain, and hence the contribution of the hot carrier can be decreased. If the film thickness is 1/2, the contribution of the hot carrier can be reduced down to 1/2. If these two effects are combined, the deterioration by the hot carrier can be decreased down to approximately 1/3.

Next, a tenth embodiment of the present invention will be explained.

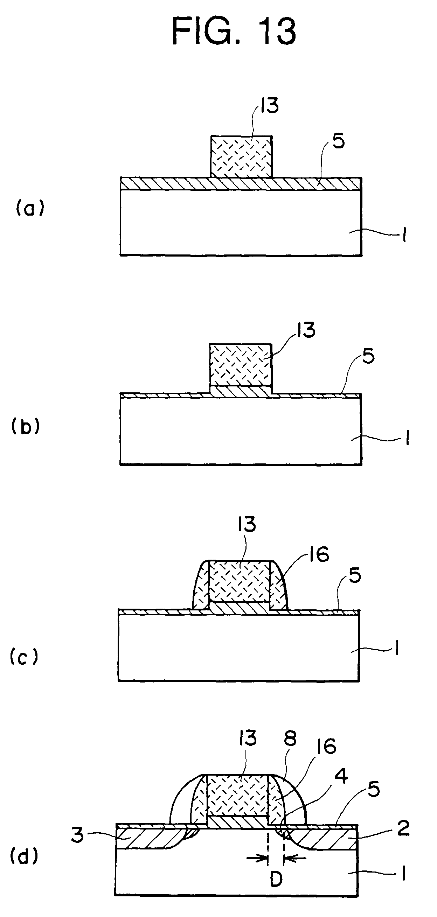

FIG. 13 is a sectional view of processes of manufacturing the MOSFET, showing the tenth embodiment of the present invention.

(1) To begin with, as illustrated in FIG. 13(a), after the gate oxide film 5 has been formed on the surface of the p-type silicon substrate 1 by a process such as the thermal oxidation, etc., the first gate electrode 13 is deposited by the technique such as sputtering, and the patterning process is implemented by the known photolithography etching technique. At this time, the oxide film 5 is not etched by employing the etching having the high selection ratio of the material of the first gate electrode 13 to the gate oxide film 5.

(2) Thereafter, the thickness of the gate oxide film 5 in the region not covered with the first gate electrode 13 is decreased as shown in FIG. 13(b) by employing an etchant of hydrofluoric acid to the silicon oxide film.

(3) Thereafter, the same material as that of the first gate electrode 13 is deposited over the whole surface, and this material is etched, whereby the second gate electrode 16 composed of the same material is, as illustrated in FIG. 13(c), in a sidewall-like shape on both sides of the first gate electrode 13.

(4) After this process, as shown in FIG. 13(d), in the same way as the ordinary MOSFET manufacturing method, the n-type low-concentration impurity layer 4, the sidewall 8 and the n-type high-concentration impurity layers 2, 3 are formed by use of those gate electrodes 13, 16, with the result that the capacity of the gate oxide film 5 in the vicinity of the drain increases.

With this arrangement, the threshold voltage becomes get lower than in the channel region, and the MOSFET having the structure in the tenth embodiment can be constructed.

As discussed above, in accordance with the tenth embodiment, the MOSFET can be constructed with no increased number of masks as compared with the prior art MOSFET manufacturing method.

According to the structure of the thus constructed MOSFET, in the vicinity of the drain, there must be the condition equivalent to the state where the gate voltage high is applied because of the gate oxide film 5 having its thickness smaller than the channel region, and hence the probability of occurrence of the hot carrier shifts leftward as indicated by the dotted line in FIG. 4. The quantity of occurrence of the hot carrier may be obtained by multiplying this by the drain current.

For this reason, supposing that the gate voltage is higher by approximately 0.5V due to the smaller thickness of the gate oxide film 5, the quantity of occurrence of the hot carrier can be reduced down to approximately 2/3.

At the same time, as the capacity of the gate oxide film 5 increases in inverse proportion to the film thickness, the contribution of the hot carrier can be decreased. If the film thickness is 1/2, the contribution of the hot carrier can be reduced down to 1/2. If these two effects are combined, the deterioration by the hot carrier can be decreased down to approximately 1/3.

Note that the embodiments discussed above have deal with the nMOS structures of the silicon substrate classified as the p-type, however, the present invention is, as a matter of course, applicable to pMOS structures of the silicon substrate classified as the n-type. In such a case, the conductivity is reverse to that in the case of the nMOS structure. Then, the first and second gate electrodes are formed by linking the two materials having the different work functions in the vicinity of the drain as well as in the P-channel region, and a front end of the low-concentration diffused drain layer is located in a part of the second gate electrode. With this arrangement, the inversion threshold voltage in the vicinity of the drain shafts farther in the plus direction by the difference in the work function than the threshold voltage in the channel region. Those twos, however, have no difference in terms of structure.

Further, the present invention is not limited to the embodiments discussed above but may be modified in many forms based on the gist of the present invention, and those modifications are not excluded from the scope of the present invention.

As described above in detail, the present invention exhibits the following effects.

(A) In the vicinity of the drain, there must be the condition equivalent to the state where the gate voltage higher by the difference in the work function than in the channel region, is applied, and the probability of occurrence of the hot carrier shifts leftward as indicated by the dotted line in FIG. 4. The quantity of occurrence of the hot carrier may be obtained by multiplying this by the drain current. For this reason, supposing that the difference in the work function is approximately 1V, the quantity of occurrence of the hot carrier can be reduced down to approximately 1/2. Simultaneously, the deterioration by the hot carrier can be also reduced down to approximately 1/2.

(B) In the vicinity of the drain, there must be the condition equivalent to the state where there is applied the gate voltage higher than in the channel region due to a difference between the substrate concentrations, and the probability of occurrence of the hot carrier shifts leftward as indicated by the dotted line in FIG. 4. The quantity of occurrence of the hot carrier may be obtained by multiplying this by the drain current. For this reason, assuming that there must be the condition where the gate voltage becomes higher by 1V due to the difference between the substrate concentrations, the quantity of occurrence of the hot carrier can be reduced down to approximately 1/2, and the deterioration by the hot carrier can be also reduced down to approximately 1/2.

(C) In the vicinity of the drain, there must be the condition equivalent to the state where the high gate voltage is applied because of the smaller thickness of the gate oxide film than the channel region, and hence the probability of occurrence of the hot carrier shifts leftward as indicated by the dotted line in FIG. 4. The quantity of occurrence of the hot carrier may be obtained by multiplying this by the drain current. Therefore, supposing that there is the condition in which the gate voltage is higher by approximately 0.5V because of the smaller thickness of the gate oxide film, the quantity of occurrence of the hot carrier can be reduced down to approximately 2/3.

Simultaneously, the capacity of the gate oxide film increases in the inverse proportion to the film thickness in the vicinity of the drain, and hence the contribution of the hot carrier can be decreased. If the film thickness is 1/2, the contribution of the hot carrier can be reduced down to 1/2. If these two effects are combined, the deterioration by the hot carrier can be decreased down to approximately 1/3.

Additionally, in the present invention, MOSFET characteristics such as a drain current characteristic to the gate voltage are determined by the channel area characteristic, therefore, no sharp fluctuation is given to the MOSFET characteristics.

Differently stated, the invention relates to a semiconductor device comprising a drain 2, 4 and a channel region, and a gate 6, 7, 13 to which a voltage can be applied to control current flow in the channel region, any given portion of the channel region having a threshold voltage defining the gate voltage which can produce strong inversion in that portion, wherein the threshold voltage in the portion 2A of the channel region in the vicinity of the drain is arranged to be different from the threshold voltage in the remainder of the channel region, so as to inhibit hot carrier effects.

The concept of threshold voltage in semiconductor devices is well-known, as is the phenomenon of strong inversion, the threshold voltage being the gate voltage at which strong inversion takes place. Reference is directed to S.M. Sze, "Physics of Semiconductor Devices", 2nd Edition, John Wiley & Sons, sections 7.2.1, 7.2.2 and 8.2.2 for a discussion of these concepts.

The threshold voltage in a semiconductor device is dependent on a number of factors, as is apparent from equation (2), including, for example, semiconductor doping densities. Where these factors vary at different points within a single device, different threshold voltages may be considered to exist at these points. The effective voltage applied at different points in the channel region depends on both the gate voltage and the threshold voltage at that point, so that, in accordance with the invention, manipulation of threshold voltages allows manipulation of electric fields within the device so as to inhibit the formation of hot carriers and their injection into the gate oxide film 5. The invention is of particular importance in the case of hyperfine devices in which device dimensions are constantly being reduced by the demands of integrated circuit technology, while at the same time requiring the application of high electric fields, which inevitably result in undesirable hot carrier effects.

**Claims**

1.  A semiconductor device comprising a drain (2, 4) and a channel region, and a gate (6, 7, 13) to which a voltage can be applied to control current flow in the channel region, any given portion of the channel region having a threshold voltage defining the gate voltage which can produce strong inversion in that portion, wherein the threshold voltage in the portion (2A) of the channel region in the vicinity of the drain is arranged to be different from the threshold voltage in the remainder of the channel region, so as to inhibit hot carrier effects.

2.  A MOSFET comprising:

    first and second gate electrodes formed by linking two materials having different work functions in a N-channel region or a P-channel region and in the vicinity of a drain; and a low-concentration diffused drain layer having its front end disposed in a part of said second gate electrode,
    wherein an inversion threshold voltage in the vicinity of the drain shifts farther in a minus direction or in a plus direction by a difference in the work functions than a threshold voltage in said channel region.

3.  A method of manufacturing a MOSFET, comprising:

    a step of forming a gate oxide film on a surface of a silicon substrate and depositing a material of a first gate electrode;
    a step of executing a patterning process on said first gate electrode without etching said gate oxide film by use of an etching method exhibiting a high selection ratio of the material of said first gate electrode to said gate oxide film;
    a step of depositing a wire material, thereafter etching said wire material, and forming a second gate electrode having a different work function at least on the drain side of said first gate electrode; and
    a step of forming a low-concentration impurity layer, a sidewall and a source/drain composed of a high-concentration impurity layer by use of said first gate electrode and said second gate electrode.

4.  A method of manufacturing a MOSFET, comprising:

a step of forming a gate oxide film on a surface of a silicon substrate, depositing a sacrifice film by a material exhibiting a high selection ratio to said gate oxide film, thereafter forming a groove in said sacrifice film, and depositing a wire material on the entire surface of said silicon substrate by a CVD technique;
a step of making said wire material remain inwardly of said groove, thereafter completely removing said sacrifice film by etching, and thus forming a first gate electrode;
a step of depositing a wire material different from said wire material on the entire surface of said silicon substrate, thereafter etching said wire material, and thus forming a second gate electrode having a different work function at least on a drain side of said first gate electrode; and a step of forming a low-concentration impurity layer, a sidewall and a source/drain composed of a high-concentration impurity layer by use of said first gate electrode and said second gate electrode.

5.  A method of manufacturing a MOSFET, comprising:

    a step of forming a gate oxide film on a surface of a silicon substrate, thereafter depositing a material of a first gate electrode, and executing a patterning process on said first gate electrode without etching said gate oxide film by use of an etching method exhibiting a high selection ratio of the material of said first gate electrode to said gate oxide film;
    a step of depositing a material of said second gate electrode on an outer periphery of said first gate electrode on an outer periphery of said first gate electrode by selective CVD, and thus forming a second gate electrode having a different work function on the outer periphery of said first gate electrode; and
    a step of forming a low-concentration of impurity layer, a sidewall and a source/drain composed of a high-concentration impurity layer by use of said first gate electrode and said second gate electrode.

6.  A method of manufacturing a MOSFET, comprising:

    a step of forming a gate oxide film on a surface of a silicon substrate, thereafter depositing a material of a first gate electrode and executing a patterning process on said first gate electrode without etching said gate oxide film by use of an etching method exhibiting a high selection ratio of the material of said gate electrode to said gate oxide film;
    a step of depositing such a wire material as forming silicide that reacts to silicon and is stable at a high temperature, thereafter forming a silicide layer on an outer periphery of said first gate electrode by effecting a high-temperature thermal treatment, and forming a second gate electrode having a different work function on the outer periphery of said first gate electrode by selectively removing said non-reacted wire material; and

a step of forming a low-concentration impurity layer, a sidewall and a source/drain composed of a high-concentration impurity layer by use of said first gate electrode and said second gate electrode.

7. A MOSFET comprising:

a channel region; and

a drain,
wherein a substrate concentration $N_{ch}$ of said channel region is different from a substrate concentration $N_D$ in the vicinity of said drain, and an inversion threshold voltage in the vicinity of said drain shifts farther corresponding to a difference between the substrate concentrations in a minus direction than a threshold voltage in said channel region.

8. A method of manufacturing a MOSFET, comprising:

a step of forming a gate oxide film on a surface of a silicon substrate of a first conductivity type or a second conductivity type, thereafter depositing a material of a first gate electrode, and executing a patterning process on said first gate electrode without etching said gate oxide film by use of an etching method exhibiting a high selection ratio of the material of said gate electrode to said gate oxide film;

a step of implanting ions at an acceleration voltage to such a degree that a first conductivity type impurity is implanted through said first gate electrode into a substrate surface;

a step of depositing a material on an entire surface, etching the material, and forming a second gate electrode composed of the same material in a sidewall-like shape on both sides of said first gate electrode; and

a step of forming a low-concentration impurity layer, a sidewall and a second conductive type or first conductivity type source/drain composed of a high-concentration impurity layer by use of said first gate electrode and said second gate electrode.

9. A method of manufacturing a MOSFET, comprising:

a step of forming a gate oxide film on a surface of a silicon substrate of a first conductivity type or a second conductivity type, thereafter depositing a material of a first gate electrode, and executing a patterning process on said first gate electrode without etching said gate oxide film by use of an etching method exhibiting a high selection ratio of the material of said gate electrode to said gate oxide film;

a step of implanting ions at an acceleration voltage to such a degree that a second conductivity type impurity is implanted into a substrate surface;

a step of depositing the same material as that of said first gate electrode on an entire surface, etching the material, and forming a second gate electrode in a sidewall-like shape on both sides of said first gate electrode; and

a step of forming a low-concentration impurity layer, a sidewall and a second conductive type or first conductivity type source/drain composed of a high-concentration impurity layer by use of said first gate electrode and said second gate electrode.

10. A MOSFET comprising:

a source/drain region formed on a silicon substrate; and

a gate electrode,
wherein a gate oxide film is so formed as to be small in thickness in the vicinity of a drain with respect to said gate electrode, a capacity of an inversion threshold voltage of said gate oxide film in the vicinity of the drain consequently becomes larger than a threshold voltage in a channel region, and the inversion threshold voltage in the vicinity of the drain thereby shifts in a minus direction.

11. A method of manufacturing a MOSFET, comprising:

a step of forming a gate oxide film on a surface of a silicon substrate, thereafter depositing a material of a first gate electrode, and executing a patterning process on said first gate electrode without etching said gate oxide film by use of an etching method exhibiting a high selection ratio of the material of said gate electrode to said gate oxide film;

a step of decreasing a thickness of said gate oxide film in a region that is not covered with said first gate electrode by using an etchant with respect to a silicon oxide film;

a step of depositing a material on an entire surface, etching the material, and forming a second gate electrode in a sidewall-shape on both sides of said first gate electrode; and

a step of forming a low-concentration impurity layer, a sidewall and a source/drain composed of a high-concentration impurity layer by use of said first gate electrode and said second gate electrode.

# FIG. 1

# FIG. 2

(a)

Vaccum Level

$q\phi_m$

$q\phi_{Si}$

$E_F$       $E_C$

$E_F$

$E_V$

Gate Material  SiO₂  p-Silicon

(b)

Vaccum Level

$q\phi_m$

$q\phi_{Si}$

$E_F$       $E_C$

$E_F$

$E_V$

Gate Material  SiO₂  p-Silicon

# FIG. 3

# FIG. 4

# FIG. 5

(a)

(b)

(c)

(d)

# FIG. 6

(a)

(b)

(c)

(d)

# FIG. 7

(a)

(b)

(c)

# FIG. 8

(a)

(b)

(c)

(d)

# FIG. 9

# FIG. 10

IMPURITY

(a)

(b)

(c)

(d)

# FIG. 11

IMPURITY

(a)

(b)

(c)

(d)

# FIG. 12

# FIG. 13

(a)

(b)

(c)

(d)

# FIG. 14

# FIG. 15

(a)

(b)